# EUROPÄISCHE PATENTSCHRIFT

(11) **EP 3 236 542 B1**
(45) Veröffentlichungstag und Bekanntmachung des Hinweises auf die Patenterteilung: **21.10.2020**
(21) Anmeldenummer: 17167014.4
(22) Anmeldetag: 19.04.2017
(51) Int. Cl.: H01R 31/06, G01R 1/24, G01R 15/18, G01R 19/10

(54) **ELEKTRISCHE GERÄTEANSCHLUSSLEITUNG**
ELECTRICAL DEVICE CONNECTION LINE
CONDUITE DE RACCORDEMENT ÉLECTRIQUE D'APPAREIL

(30) Priorität: 20.04.2016 DE 202016102071 U
(43) Veröffentlichungstag der Anmeldung: 25.10.2017
(73) Patentinhaber: Kalthoff GmbH, 58579 Schalksmühle (DE)
(72) Erfinder: Tertel, Gundolf, 58540 Meinerzhagen (DE)
(74) Vertreter: Patentanwälte Dörner & Kötter PartG mbB

(56) Entgegenhaltungen:
- EP-A1- 2 112 721
- EP-A2- 2 280 454
- CN-B- 102 904 121
- DE-A1-102006 021 859
- US-B1- 6 790 086

## Beschreibung

Die Erfindung betrifft eine elektrische Geräteanschlussleitung mit einem Kabelmantel, in dem mindestens ein Schutzleiter, ein Phasenleiter und ein Nullleiter angeordnet sind und an deren beiden Enden jeweils ein Kopplungsstück anbringbar ist.

Elektrische Geräteanschlussleitungen der vorgenannten Art sind in vielfältiger Weise bekannt. Sie bestehen aus einer flexiblen Netzzuleitung, die an ihren beiden Enden jeweils mit einem Kopplungsstück versehen ist. Bei dem Kopplungsstück handelt es sich üblicherweise einerseits um einen Netzstecker, vorzugsweise einen Schutzkontaktstecker, andererseits um einen Geräteanschlussstecker oder eine Geräteanschlusssteckdose, mit dem verschiedenste Verbraucher an die elektrische Gebäudeinstallation angeschlossen werden können. Ein Kopplungsstück im Sinne der vorliegenden Erfindung kann darüber hinaus auch eine Netzsteckdose oder eine andere elektrische Kupplung sein.

Für einen zuverlässigen Betrieb der elektrischen Verbraucher ist es in bestimmten Bereichen vorgeschrieben, die Geräte hinsichtlich ihrer Sicherheit und Funktion zu überprüfen. Hierbei sind auch Prüfungen bekannt, die im laufenden Betrieb des jeweiligen Verbrauchers erfolgen müssen. Eine dieser Prüfungen ist die so genannte "Differenzstrommessung", bei der auf das zu prüfende Gerät die Netzspannung geschaltet wird, um dieses in einen aktiven Betriebszustand zu versetzen. Das verwendete Messgerät vergleicht hineinfließende und abfließende Ströme und ermittelt so den Differenzstrom. Auf diese Weise werden sämtliche Ströme erfasst, die über das Erdpotential abfließen.

Zwar ist die genannte Art der Messung grundsätzlich zulässig; es können jedoch Umstände eintreten, bei denen diese Art der Messung kein zuverlässiges Ergebnis liefert, beispielsweise dann, wenn die Rückführung des Stroms nicht über den Nullleiter, sondern aufgrund eines Schadens innerhalb des Gerätes zumindest teilweise über den Schutzleiter zurückgeführt wird. Für diesen Fall liefert die beschriebene Methode kein zuverlässiges Ergebnis.

Zur Vermeidung dieses Schwachpunktes ist es bekannt, den Schutzleiter von dem Nullleiter und dem Phasenleiter zu trennen, um an dem Schutzleiter (Fehler-) Ströme messen zu können. Für die Überprüfung der Geräte nach diesem Prinzip sind Adapter bekannt, die eine Messung allein des Schutzleiters ermöglichen. Der Einsatz solcher Adapter erfordert jedoch das Abschalten des jeweiligen Geräts, das Einstecken des Adapters und das erneute Einschalten des Geräts. Nach der Messung muss das Gerät dann erneut abgeschaltet werden, um den Adapter zu entfernen. Neben dem hierfür anfallenden Zeitaufwand für die Überprüfung des Geräts ist es unter bestimmten Bedingungen kaum möglich, das zu prüfende Gerät abzuschalten, beispielsweise im medizinischen Bereich oder auch bei Servern innerhalb von Computernetzwerken usw.

Um diese Nachteile zu vermeiden beschreibt beispielsweise die DE 10 2006 021 859 A1 einen Steckverbinder nach Art eines Schutzkontaktsteckers mit einer Zuleitung, bei dem in dem Steckergehäuse der Schutzleiter von dem Nullleiter und dem Phasenleiter getrennt verläuft und in dem Steckverbinder eine Öffnung für den Ansatz eines Messgeräts gebildet ist. Auf diese Weise besteht mit einem üblichen Messgerät wie beispielsweise einer Messzange die Möglichkeit, allein die stromführenden Leiter abzugreifen.

Zwar erfüllt der bekannte Steckverbinder die Anforderungen in Bezug auf die Prüfung mit Hilfe der Differenzstrommessung; er weist jedoch den Nachteil auf, dass er aufgrund seiner Abmessungen unter einer Vielzahl von Einsatzbedingungen nicht verwendbar ist. Beispielsweise ist eine Anbringung des Steckverbinders in so genannten Kabelkanälen von Schreibtischen oder unter anderen beengten Platzverhältnissen kaum möglich. Zudem sind die Herstellkosten für den bekannten Steckverbinder im Vergleich zu üblichen Schutzkontaktsteckern mit einer Zuleitung relativ hoch.

Dokumente EP 2 280 454 A2 und US 6 790 086 B1 offenbaren den Oberbegriff von Anspruch 1.

Vor diesem Hintergrund liegt der Erfindung die Aufgabe zu Grunde, eine einfache, platzsparende und zugleich kostengünstige Lösung für die zuverlässige Durchführung für das Differenzstrommessverfahren bereitzustellen, ohne eine Trennung der Geräte von der Netzversorgung vornehmen zu müssen. Gemäß der Erfindung wird diese Aufgabe durch eine elektrische Geräteanschlussleitung gelöst, bei der der Kabelmantel an mindestens einer Stelle getrennt ist und der Schutzleiter in der Trennstelle von dem Nullleiter und dem Phasenleiter separat verläuft, und dass im Bereich der Trennstelle eine Umspritzung vorgesehen ist, die mit einer Öffnung versehen ist, und der Schutzleiter von dem Nullleiter und dem Phasenleiter getrennt verläuft.

Mit der Erfindung ist eine elektrische Geräteanschlussleitung geschaffen, die eine zuverlässige messtechnische Überprüfung der Geräte ermöglicht, ohne die Geräte vom Netz trennen zu müssen. Gleichzeitig ist durch die Trennung der stromführenden Leiter vom Schutzleiter eine alleinige Prüfung des Schutzleiters mit einem Messgerät möglich. Aufgrund der einfachen Integration der Trennung der stromführenden Leiter von dem Schutzleiter innerhalb der Geräteanschlussleitung ist zudem eine außerordentlich preiswerte Lösung geschaffen, die bereits bei Inbetriebnahme des jeweiligen Geräts Verwendung finden kann, so dass zu jeder Zeit eine für die Durchführung des Differenzstrommessverfahrens geeignete Anordnung vorhanden ist. Mithilfe der Umspritzung ist die außerhalb der Trennstelle durch den Kabelmantel hervorgerufene Sicherung der Leiter gegen Beschädigung geschaffen, so dass auch im Bereich der Trennstelle eine ausreichende Absicherung gegen Beschädigung, Feuchtigkeit und dergleichen bereitgestellt ist.

Bevorzugt weisen im Bereich der Trennstelle der Nullleiter und der Phasenleiter eine gemeinsame Ummantelung auf und der Schutzleiter weist eine eigene Ummantelung auf. Durch diese Ausgestaltung ist dem Bedürfnis, im Rahmen des Differenzstrommessverfahrens lediglich den Schutzleiter zu überprüfen, Rechnung getragen. Gleichzeitig ist den Erfordernissen an eine Isolierung der Leiter Genüge getan.

In vorteilhafter Weiterbildung der Erfindung ist in die Umspritzung ein Ring integriert. Die Integration des Rings führt zu einer kreisrunden Öffnung innerhalb der Geräteanschlussleitung. Diese eignet sich einerseits für das Ansetzen eines Messgeräts, beispielsweise in Form einer Messzange, andererseits bietet diese Ausgestaltung die Möglichkeit, das Kabel in einfacher Weise bei Nichtbenutzung an einem Haken aufzuhängen.

In Ausgestaltung der Erfindung überdeckt die Umspritzung den Kabelmantel bereichsweise. Hierdurch ist gewährleistet, dass eine zuverlässige Abdichtung auch der Leiter im Bereich der Trennstelle gewährleistet ist.

In weiterer Ausgestaltung der Erfindung ist die Umspritzung mit einer Zugentlastung versehen. Diese Ausgestaltung erhöht die Betriebssicherheit zusätzlich, da auch bei einem übermäßigen Ziehen an der Geräteanschlussleitung an einem Ende der Leitung oder im Bereich der Trennstelle, sei es in benutztem oder auch in unbenutztem Zustand, nicht unmittelbar zu einer Zerstörung der Leitung führt.

In anderer Weiterbildung der Erfindung weisen der Schutzleiter, der Phasenleiter und der Nullleiter im Bereich der Trennstelle jeweils eine eigene Ummantelung auf. Diese Ausgestaltung führt zu einer Trennung aller drei Leiter, so dass neben der an sich gewünschten Trennung des Schutzleiters von den stromführenden Leitern bei dieser Ausgestaltung auch eine Trennung der stromführenden Leiter von einander möglich ist, so dass grundsätzlich die Möglichkeit besteht, jeden Leiter der Geräteanschlussleitung einzeln oder bei Bedarf in Kombination mit irgendeinem der anderen Leiter zu überprüfen. So kann zum Beispiel durch die getrennte Messung des Nullleiters oder des Phasenleiters der Stromverbrauch des Gerätes gemessen werden.

Andere Weiterbildungen und Ausgestaltungen der Erfindung sind in den übrigen Unteransprüchen angegeben. Ausführungsbeispiele der Erfindung sind in den Zeichnungen dargestellt und werden nachfolgend im Einzelnen beschrieben. Es zeigen:

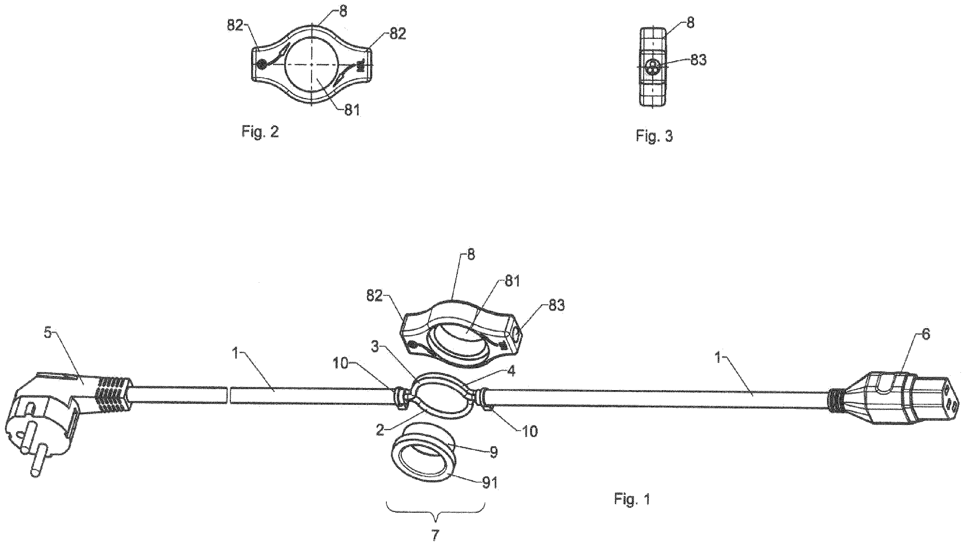

- Figur 1: die Darstellung einer erfindungsgemäßen Geräteanschlussleitung in explosionsartiger Darstellung der Trennstelle mit Umspritzung und Ring;
- Figur 2: die Draufsicht auf die Umspritzung;
- Figur 3: die Seitenansicht von links der in Figur 2 dargestellten Umspritzung.

Die als Ausführungsbeispiel gewählte elektrische Geräteanschlussleitung besteht aus einer elektrischen Leitung, die mit einem Kabelmantel 1 umgeben ist. In dem Kabelmantel 1 sind ein Schutzleiter 2, ein Nullleiter 3 und ein Phasenleiter 4 angeordnet. Die Leiter 3 und 4 sind die stromführenden Leiter der Geräteanschlussleitung. Die Leiter 2 bis 4 sind von Adern gebildet, die aus Kupfer hergestellt sind. Die Adern selbst sind mit einer Isolierung ummantelt.

An beiden Enden der Geräteanschlussleitung sind Kopplungsstücke anbringbar. Im Ausführungsbeispiel ist an dem einen Ende ein Schutzkontaktstecker 5 angeordnet, wie er handelsüblich ist. An dem dem Schutzkontaktstecker 5 abgewandten Ende ist eine Geräteanschlusssteckdose 6 vorgesehen, bei der es sich um eine Netzanschlusssteckdose für einen Computer handelt. Die im Ausführungsbeispiel dargestellte Geräteanschlussleitung stellt ein so genanntes "Kaltgeräte-Anschlusskabel" dar.

Der Kabelmantel 1 ist im Ausführungsbeispiel in der Mitte der Geräteanschlussleitung getrennt, wodurch eine Trennstelle 7 hervorgerufen ist. In der Trennstelle 7 verläuft der Schutzleiter 2 von dem Nullleiter 3 und dem Phasenleiter 4 separat. Folglich sind die stromführenden Leiter 3 und 4 von dem nicht stromführenden Schutzleiter 2 getrennt. Im Bereich der Trennstelle 7 ist eine Umspritzung 8 vorgesehen, die ebenfalls aus Kunststoff hergestellt ist. Die Umspritzung 8 ist im Ausführungsbeispiel mit einer kreisrunden Öffnung 81 versehen. Andere Formen für die Öffnung sind selbstverständlich ebenfalls möglich. Die Umspritzung 8 weist zwei einander diametral gegenüberliegende Ansätze 82 auf, die mit Leitungseintrittsöffnungen 83 versehen sind.

Im Ausführungsbeispiel nimmt die Umspritzung 8 einen Ring 9 auf, der an seinem einen Ende mit einer ringförmigen Durchmessererweiterung 91 versehen ist. In montiertem Zustand der Umspritzung 8 und des Rings 9 sind die Leiter 2 bis 4 um den Ring 9 herumgeführt und liegen an der Durchmessererweiterung 91 an. Die Durchmessererweiterung 91 schließt in montiertem Zustand die Umspritzung 8 an ihrem Boden ab. Gleichzeitig überdeckt die Umspritzung 8 in montiertem Zustand den Kabelmantel 1 bereichsweise mit Hilfe der Ansätze 82. Im Bereich der Ansätze 82 ist an dem Kabelmantel 1 jeweils eine Zugentlastung 10 vorgesehen.

Bei der Herstellung der erfindungsgemäßen Geräteanschlussleitung wird eine herkömmliche Geräteanschlussleitung in dem gewünschten Bereich aufgeschnitten, so dass der Kabelmantel 1 bereichsweise entfernt ist. Durch Verwendung geeigneter Werkzeuge besteht dabei nicht die Gefahr, dass die Leiter 2 bis 4 beim Auftrennen des Kabelmantels 1 Schaden nehmen. Sodann wird die Trennstelle 7 in eine Bearbeitungsmaschine eingelegt, in der bereits der Ring 9 positioniert ist. Gleichzeitig werden beim Einlegen der Nullleiter 3 und der Phasenleiter 4 auf der einen Seite des Rings 9 entlang geführt, der Schutzleiter 2 auf der anderen Seite des Rings 9, so dass diese voneinander getrennt sind.

Sodann wird die Vorrichtung geschlossen und Kunststoff in die Vorrichtung eingespritzt, die dann die Form der Umspritzung 8 nachbildet. Es wird so einerseits ein dichter Verbund zwischen der Umspritzung 8 und dem Ring 9 hergestellt, andererseits ein dichter Verbund zwischen den Ansätzen 82 der Umspritzung 8 und dem Kabelmantel 1. Auf diese Weise ist eine elektrische Geräteanschlussleitung geschaffen, die die Anwendung des Differenzstrommessverfahrens bei gleichzeitiger Messung allein des Schutzleiters 2 ermöglicht. Durch die Verwendung handelsüblicher Stecker jeglicher Art sowohl auf der Geräteanschlussseite als auch auf der Netzspannungsseite bestehen keine Probleme hinsichtlich ihrer Kompatibilität. Gleichzeitig ist auch die Verwendung innerhalb von Kabelschächten oder dergleichen problemlos möglich.

In Abwandlung des Ausführungsbeispiels besteht auch die Möglichkeit, anstelle der Umspritzung 8 im Bereich der Trennstelle 7 den Schutzleiter 2, den Nullleiter 3 und den Phasenleiter 4 jeweils mit einer eigenen Ummantelung zu versehen, wodurch drei separate Leiter hervorgerufen sind, die jeweils für sich oder in Kombination mit anderen Leitern geprüft werden können. Auch ist es in Abwandlung des Ausführungsbeispiels im Bereich der Trennstelle möglich, dass der Nullleiter 3 und der Phasenleiter 4 eine gemeinsame Ummantelung aufweisen und der Schutzleiter 2 eine eigene Ummantelung aufweist. Auch hierdurch ist die Messung nach dem Differenzstrommessverfahren möglich, wobei auch hier die Möglichkeit besteht, den Schutzleiter von den stromführenden Leitern getrennt auszumessen.

In einer weiteren Abwandlung des Ausführungsbeispiels besteht die Möglichkeit, den Schutzleiter 2, den Nullleiter 3 und den Phasenleiter 4 im Bereich der Trennstelle zu vercrimpen. Bei dieser Variante wird die Geräteanschlussleitung an der gewünschten Trennstelle durchtrennt. Es werden dann Zwischenstücke von Schutzleiter, Phasenleiter und Nullleiter mit den Leitern der Geräteanschlussleitung vercrimpt und anschließend isoliert. Die Leiter können auch bei dieser Ausführung einzeln isoliert werden. Es ist aber auch möglich, die stromführenden Leiter gemeinsam zu isolieren und den Schutzleiter davon getrennt zu isolieren. Selbstverständlich besteht auch die Möglichkeit, die oben beschriebene Umspritzung vorzusehen. Auf diese Weise ist die Möglichkeit einer weiteren Art der Erstellung der erfindungsgemäßen Geräteanschlussleitung geschaffen.

## Patentansprüche

1. Elektrische Geräteanschlussleitung mit einem Kabelmantel (1), in dem mindestens ein Schutzleiter (2), ein Nullleiter (3) und ein Phasenleiter (4) angeordnet sind und an deren beiden Enden jeweils ein Kopplungsstück (5, 6) anbringbar ist, wobei der Kabelmantel (1) an mindestens einer Stelle getrennt ist und der Schutzleiter (2) in der Trennstelle (7) von dem Nullleiter (3) und dem Phasenleiter (4) separat verläuft, **dadurch gekennzeichnet, dass** im Bereich der Trennstelle (7) eine Umspritzung (8) vorgesehen ist, die mit einer Öffnung (81) versehen ist und der Schutzleiter (2) im Bereich der Trennstelle (7) von dem Nullleiter (3) und dem Phasenleiter (4) getrennt verläuft.

2. Geräteanschlussleitung nach Anspruch 1, **dadurch gekennzeichnet, dass** im Bereich der Trennstelle der Nullleiter (3) und der Phasenleiter (4) eine gemeinsame Ummantelung aufweisen und der Schutzleiter (2) eine eigene Ummantelung aufweist.

3. Geräteanschlussleitung nach Anspruch 1 oder 2, **dadurch gekennzeichnet, dass** in die Umspritzung (8) ein Ring (9) integriert ist.

4. Geräteanschlussleitung nach einem der vorgenannten Ansprüche, **dadurch gekennzeichnet, dass** die Umspritzung (8) den Kabelmantel (1) bereichsweise überdeckt.

5. Geräteanschlussleitung nach einem der vorgenannten Ansprüche, **dadurch gekennzeichnet, dass** die Umspritzung (8) mit einer Zugentlastung versehen ist.

6. Geräteanschlussleitung nach Anspruch 1, **dadurch gekennzeichnet, dass** im Bereich der Trennstelle (7) der Schutzleiter (2), der Nullleiter (3) und der Phasenleiter (4) jeweils eine eigene Ummantelung aufweisen.

## Claims

1. Electrical device connection line with a cable sheath (1), in which at least one protective conductor (2), one neutral conductor (3) and one phase conductor (4) are arranged and a coupling piece (5, 6) can be respectively mounted to both ends thereof, wherein the cable sheath (1) is separated at at least one point and the protective conductor (2) runs separately from the neutral conductor (3) and the phase conductor (4) in the separation point (7), **characterised in that** an encapsulation (8) is provided in the region of the separation point (7), which is provided with an opening (81) and the protective conductor (2) runs separately from the neutral conductor (3) and the phase conductor (4) in the region of the separation point (7).

2. Device connection line according to claim 1, **characterised in that** in the region of the separation point, the neutral conductor (3) and the phase conductor (4) have a common sheath and the protective conductor (2) has a separate sheath.

3. Device connection line according to claim 1 or 2, **characterised in that** a ring (9) is integrated in the encapsulation (8).

4. Device connection line according to one of the previous claims, **characterised in that** the encapsulation (8) partially covers the cable sheath (1).

5. Device connection line according to one of the previous claims, **characterised in that** the encapsulation (8) is provided with a strain relief.

6. Device connection line according to claim 1, **characterised in that** in the region of the separation point (7), the protective conductor (2), the neutral conductor (3) and the phase conductor (4) each have their own sheath.

## Revendications

1. Ligne de raccordement électrique d'appareil comprenant une gaine (1) de câble dans laquelle sont disposés au moins un conducteur de terre (2), un conducteur de neutre (3) et un conducteur de phase (4), et au deux extrémités de laquelle peut être fixé respectivement une pièce de couplage (5, 6), sachant que la gaine (1) de câble est sectionnée à au moins un endroit et que le conducteur de terre (2) circule séparément, au point de séparation (7), du conducteur de neutre (3) et du conducteur de phase (4), **caractérisée en ce que** dans la zone du point de séparation (7) est prévue un enrobage injecté (8) muni d'une ouverture (81) et que le conducteur de terre (2) présente, dans la zone du point de séparation (7), un tracé séparé du conducteur de neutre (3) et du conducteur de phase (4).

2. Ligne de raccordement d'appareil selon la revendication 1, **caractérisée en ce que** dans la zone du point de séparation le conducteur de neutre (3) et le conducteur de phase (4) possèdent une gaine commune et que le conducteur de terre (2) possède sa propre gaine.

3. Ligne de raccordement d'appareil selon la revendication 1 ou 2, **caractérisée en ce qu'**une bague (9) est intégrée dans l'enrobage injecté (8).

4. Ligne de raccordement d'appareil selon l'une des revendications précédentes, **caractérisée en ce que** l'enrobage injecté (8) recouvre localement la gaine (1) de câble.

5. Ligne de raccordement d'appareil selon l'une des revendications précédentes, **caractérisée en ce que** l'enrobage injecté (8) est muni d'un décharge de traction.

6. Ligne de raccordement d'appareil selon la revendication 1, **caractérisée en ce que** dans la zone du point de séparation (7) le conducteur de terre (2), le conducteur de neutre (3) et le conducteur de phase (4) présentent chacun leur propre gaine.
